Europäisches Patentamt

European Patent Office

Office européen des brevets

(19)

(11) Publication number: **0 076 566**
**B1**

(12) **EUROPEAN PATENT SPECIFICATION**

(45) Date of publication of patent specification: 07.05.86

(21) Application number: 82304332.8

(22) Date of filing: 17.08.82

(51) Int. Cl.⁴: **F 16 C 32/06,** H 01 L 21/68,
H 01 J 37/20

(54) Gasborne stage positioner for two directions X and Y.

(30) Priority: 21.09.81 US 304228

(43) Date of publication of application:
13.04.83 Bulletin 83/15

(45) Publication of the grant of the patent:
07.05.86 Bulletin 86/19

(84) Designated Contracting States:
DE FR GB

(56) References cited:
DE-B-1 220 228
US-A-3 803 924
US-A-4 191 385

Patent Abstracts of Japan, vol. 3, no. 35, 24
March 1979, page 129M53

Patent Abstracts of Japan, vol. 3, no. 107, 8.
September 1979, page 133E136

(73) Proprietor: **CONTROL DATA CORPORATION**
**8100-34th Avenue South**
**Minneapolis Minnesota 55440 (US)**

(72) Inventor: **Tucker, Theodore Worth**
**Winter Street**
**Lincoln Massachusetts 01772 (US)**

(74) Representative: **Caro, William Egerton et al**
**J. MILLER & CO. Lincoln House 296-302 High**
**Holborn**
**London WC1V 7JH (GB)**

EP 0 076 566 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a gas borne stage positioner for two directions X and Y.

In the semiconductor industry, electron beam devices are used in the manufacture of semiconductor wafers and masks. Generally speaking these electron beam devices require a high vacuum environment to perform their function efficiently. In most electron beam devices, a target wafer or mask is mounted on a movable platform known as a stage. Such stages are normally required to move in an X—Y plane in many minute and precise movements. Accordingly, it is desirable that they be mounted on gas bearings.

In JP—A—54-85678, there is disclosed a gas borne X—Y plane stage positioner comprising first, second and third assemblies, constraining means between the first and second assemblies to constrain the relative movement therebetween to a first direction, constraining means between the second and third assemblies to constrain the relative movement therebetween to a second direction orthogonal to the first direction, gas bearing means between the first and second assemblies and gas bearing means between the second and third assemblies.

The stage thus disclosed is not compatible with a high vacuum environment, such as the vacuum chamber of an electron beam device. There are many problems providing a gas bearing in a high vacuum environment in a vaccum chamber of an electron beam device. The problems have heretofore been approached by providing an air bearing external to the vacuum chamber with the stage mounted on an arm extending into the vaccum chamber. This solution has the inherent problem of instability at the end of the arm. Another approach is to provide high vacuum pumps at the periphery of the air bearing to remove the air as it exits the periphery of the air bearing. However, this is both non-ideal and very expensive.

A third approach is suggested in US—A—4,191,385 where the vacuum chamber is provided interior of the air bearing. This solution has the inherent problem of a large massive structure. Minute, precise movements are not indicated.

According to the present invention there is provided a gas borne stage positioner for two directions X and Y comprising first, second and third assemblies of which the first is stationary, constraining means between the first and second assemblies to constrain the relative movement therebetween to a first direction, constraining means between the second and third assemblies to constrain the relative movement therebetween to a second direction orthogonal to the first direction, gas bearing means between the first and second assemblies and gas bearing means between the second and third assemblies, characterised in that the movable second assembly includes a gas-tight housing with a central plate mounted therein, that the first and third assemblies includes carriages within the housing on either side of the central plate, that a gas inlet port is mounted on each carriage the ports extending through an aperture in the housing, that a gas outlet port is mounted on each carriage through an aperture in the housing, that the gas bearing means include a plurality of orifices on the exterior surface of each carriage facing closely adjacent surfaces of the second assembly, that a first passageway in each carriage extends between the respective inlet port and orifices, that a second passageway in each carriage extends from the exterior surface of the carriage within the housing to the respective outlet port, that a gas-tight bellows is mounted between each aperture and the outlet or inlet port extending therethrough and forming a gas-tight seal therebetween and that a stage (74) is mounted exterior to said housing on the inlet and outlet ports (22, 24) of the carriage (18) of the third assembly so that said stage is free to move in an X—Y plane relative to the first assembly and that a source of pressurised gas communicates with the inlet ports so that the stage positioner is operable with the gas tight housing located in vacuum.

Other characterising features of the invention are set forth in the appended claims which define the scope thereof.

The invention is illustrated, merely by way of example, in the accompanying drawings, in which:—

Figure 1 is a top cross sectional view of one embodiment of an air bearing X—Y plane positioning stage according to the present invention;

Figure 2 is a partial cut-away perspective view of the air bearing stage of Figure 1;

Figure 3 is a cross-section of the air bearing stage of Figure 1 taken along the line 3—3;

Figure 4 is an exploded view of the air bearing stage of Figure 1; and

Figure 5 is a top plan view of a central plate of the air bearing stage of Figure 1.

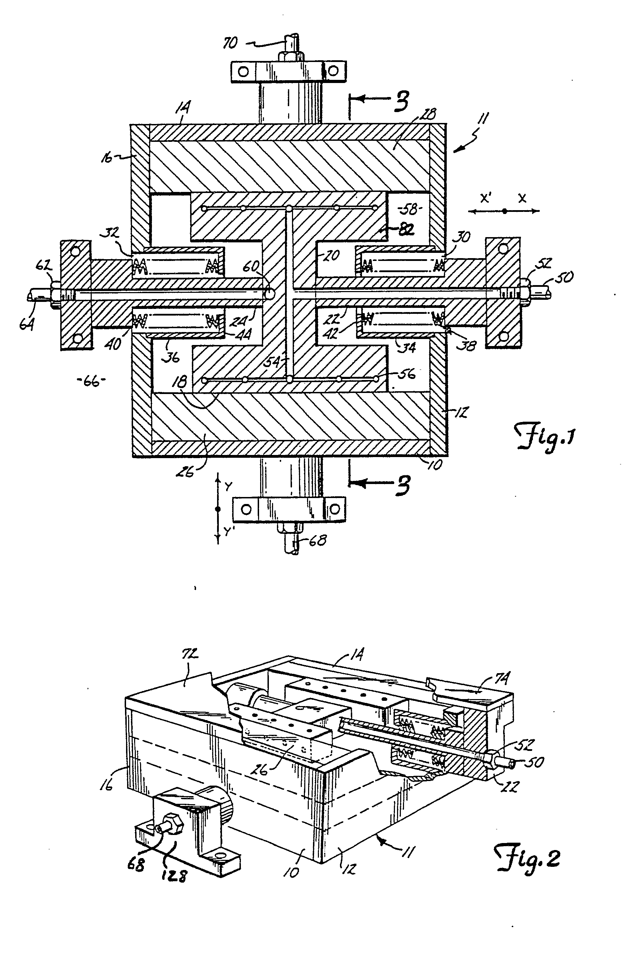

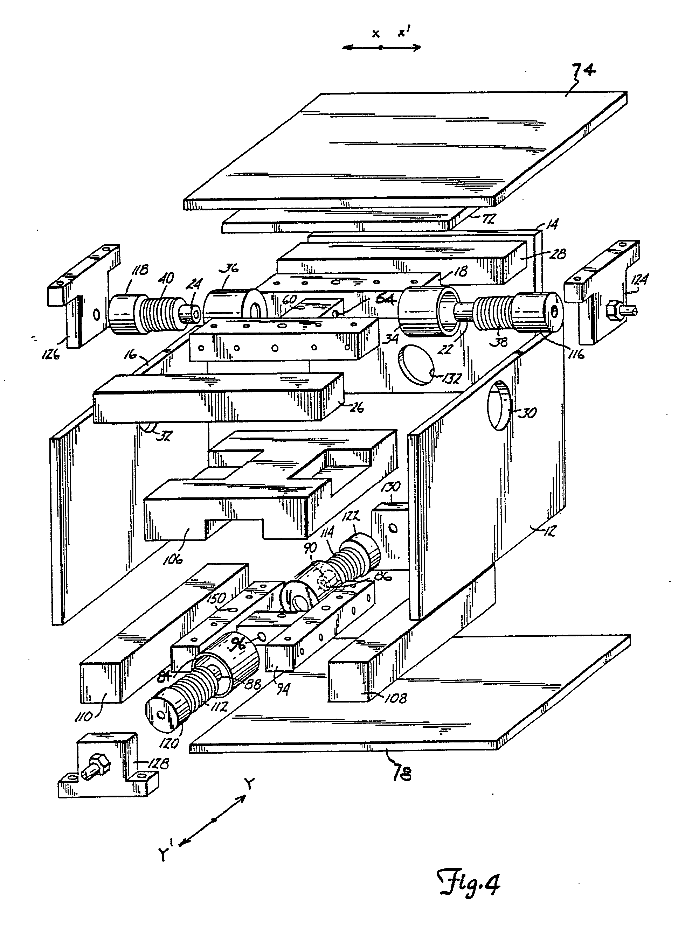

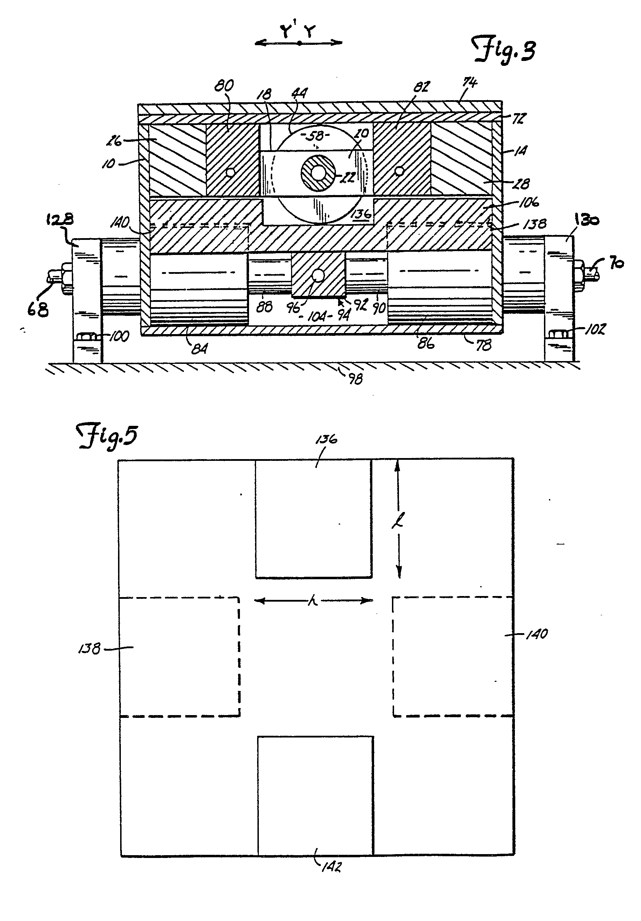

In the embodiment of stage according to the present invention illustrated in Figure 1, an airtight chamber 11 consists of side plates 10, 12, 14, 16, a top plate 72 (Figure 3) and a bottom plate 78. Mounted in the chamber is an upper carriage 18 and a lower carriage 94 (Figure 4) which are identical but orthogonally mounted relative to one another. The carriage 18 is in the form of the letter H having a central member 20 and lateral members 80, 82. Mounted on one side of the central member 20 is an air inlet port 22 which moves with the carriage 18. Mounted on the other side of the central member 20 is an air outlet port 24 which also moves with the carriage. The carriage 18 is constrained to move in one direction by laterally mounted rails 26, 28, the direction and distance of movement being denoted by vectors X and X'. The ports 22, 24 extend through apertures 30, 32 in the side plates 12, 16, respectively, of the chamber 11. Cylindrical brackets 34, 36 are mounted on the side plates 12, 16 respectively, and extend inwards about the respective ports 22, 24. The airtightness of the chamber 11 is maintained by flexible bellows 38, 40 mounted at one end on the respective ports 22, 24 and at the other end on an inwards projecting flange 42, 44 on the inward end of the respective brackets 34, 36.

The port 22 couples to a source of pressurized air *via* flexible tubing 50 and a connector 52. The port 22 communicates this pressurized air to an interior passageway 54 of the carriage 18. This passageway communicates the pressurized air to four sets of orifices 56 mounted on four exterior surfaces of the carriage facing the rails 26, 28, a central plate 106 (Figures 3, 4 and 5) and the top plate 72 (Figures 3 and 4). The interaction of pressurized air between these closely adjacent surfaces creates a compensated air bearing.

Air exiting from between these surfaces enters a plenum chamber 58 in the chamber 11 between the central plate 106 and the top plate 72. Due to the reduced dimensions of the central member 20 (Figures 3 and 4), the air in the plenum chamber 58 is constrained to exit *via* an aperture 60 in the top of the central member 20 of the carriage 18, through the central member 20, and out through the port 24. Mounted on the port 24 by a connector 62 is flexible tubing 64, which conducts the air out of an evacuated space 66, within which the air bearing is disposed. Thus the vacuum integrity of a space 66 immediately surrounding chamber 11 is maintained.

The lower carriage 94 (the first assembly) is stationary and the chamber 11 (the second assembly) is constrained to move in a direction relative thereto which is orthogonal to the direction of relative movement of the carriage 18 (the third assembly) on the chamber 11 by rails 108, 110, the direction and distance of movement being denoted by vectors Y and Y'.

Figure 2 shows a partial cut-away view of the air bearing of Figure 1. In addition to the features shown and discussed in relation to Figure 1, Figure 2 shows portions of the top plate 72 and a stage 74. The stage 74 is mounted on mounting members 124, 126 (Figure 4) on ends 116, 118 of the ports 22, 24. The lateral extent of the stage, shown in Figure 2, is coextensive with the lateral dimensions of the exterior of the port 22, but it may be larger if desired.

The phantom lines in Figure 2 show the relative levels of the interfaces between the carriage 18, the central plate 106, and the lower carriage 94.

The lower carriage 94 has brackets 84, 86 which surround bellows 112, 114 (Figure 4), an air inlet port 88, an air outlet port 90 respectively, and a central member 92 (Figure 3) having a pressurized air communicating passageway 96. The carriage 94 is mounted on mounting members being connected to fixed structure 98 by respective bolts 100, 102. The port 90 extends through an aperture 132 in the side plate 14 and the port 88 extends through an aperture (not shown) in the side plate 10.

The upper surface of the central member 20 of the upper carriage 18 is spaced downwards from the top surface of the respective lateral members 80, 82. This forms the plenum chamber 58 which communicates pressurized air to the aperture 60.

The upper surface of the central member 92 of the lower carriage 94 is similarly spaced from the upper surface of its lateral members (Figure 4) to form a plenum chamber 104 to communicate pressurized air to an outlet aperture (not shown) located on the bottom of the central member. The lateral members of the lower carriage 94 have four sets of orifices 150 which communicate with the passageway 96 and which are mounted on four exterior surfaces of the carriage facing the rails 108, 110, the lateral plate 106 and the bottom plate 78.

The central plate 106 forming part of the second assembly has four recesses, 136, 138, 140, 142 (Figure 5). The recesses on one side of the central plate receive part of the brackets 34, 36 and the recesses on the other side of the central plate receive part of the brackets 84, 86.

The dimension $h$ of the recesses 136, 138, 140, 142 shown in Figure 5 is approximately the same as the length of the central members 20 or 92 of the carriages 18, 94. The dimension $l$ is approximately the same as the length of the brackets 34, 36, 84, 86. The depth of the recesses (Figure 3) is approximately one-half the diameter of the brackets (34, 36, 84, 86, less one-half the thickness of the central member 20, 92.

The number of orifices 56, 150, on each side of each respective lateral member of each carriage 18, 94, in the preferred embodiment, is five, as shown. However, the number, size and placement of the orifices are matters of design choice to suit the particular application of the air bearing.

In brief, the operation of the air bearing is as follows: pressurized air from a source (not shown) external to the evacuated space 66 is conducted to the port 22 via the tubing 50 and/or the port 88 via tubing 68 which need not be flexible. The air then is forced out the orifices 56 and/or the orifices 150 of the carriages 18, 94 creating two compensated air bearings, with an air buffer existing between top, bottom and lateral side surfaces of the carriage and closely adjacent surfaces. The air then enters the plenum chamber 58 and/or the plenum chamber 104 in which the carriages are mounted, and exits via the port 24 and/or the port 90 mounted on the carriages. From there the air is conducted out of the evacuated space 66 via the tubing 64 and/or tubing 70.

The airtightness of the chamber 11 is maintained by providing flexible, airtight bellows 38, 40, 112, 114. The rails 26, 28, 108, 110 allow each carriage to move unidirectionally, the directions being orthogonal. Thus, the stage 74 mounted on the carriage 18 is free to move in a horizontal X—Y plane, relative to the fixed structure 98.

**Claims**

1. A gas borne stage positioner for two directions X and Y comprising first, second and third assemblies (94, 11, 18) of which the first (94) is stationary, constraining means (108, 110, 78, 106) between the first and second assemblies (94, 11) to constrain the relative movement therebetween to a first direction Y—Y, constraining means (26, 28, 72, 106) between the second and third assemblies (11, 18) to constrain the relative movement therebetween to a second direction (X—X) orthogonal to the first direction, gas bearing means (150) between the first and second assemblies and gas bearing means (56) between the second and third assemblies, characterised in that the movable second assembly includes a gas-tight housing (11) with a central plate (106) mounted therein, that the first and third assemblies include carriages (94, 18) within the housing (11) on either side of the central plate (106), that a gas inlet port (88, 22) is mounted on each carriage (94, 18) the ports extending through apertures in the housing (11), that a gas outlet port (90, 24) is mounted on each carriage (94, 11) and extends through an aperture (132, 32) in the housing, that the gas bearing means include a plurality of orifices (150, 56) on the exterior surface of each carriage (94, 11) facing closely adjacent surfaces of the second assembly, that a first passageway (96, 54) in each carriage (94, 11) extends between the respective inlet port (88, 22) and orifices (150, 56), that a second passageway (60) in each carriage (94, 18) extends from the exterior surface of the carriage within the housing (11) to the respective outlet port (90, 24), that a gas-tight bellows (38, 40, 112, 114) is mounted between each aperture (30, 32) and the outlet or inlet port extending therethrough and forming a gas-tight seal therebetween, that a stage (74) is mounted exterior to said housing on the inlet and outlet ports (22, 24) of the carriage (18) of the third assembly so that said stage is free to move in an X—Y plane relative to the first assembly and that a source of pressurised gas communicates with the inlet ports so that the stage positioner is operable with the gas-tight housing located in vacuum.

2. A stage as claimed in claim 1, characterised in that each said constraining means includes a pair of parallel rails (26, 28; 108, 110), each pair mounted orthogonally in the housing (11) of the second assembly.

3. A stage as claimed in claim 1 or 2, characterised in that each of said carriages (18, 94) comprises two spaced parallel members (80, 82) linked by a central member (20, 92).

4. A stage as claimed in any preceding claim characterised in that said central plate (106) includes recesses in which said bellows (38, 40; 112, 114) are partially located.

5. A stage as claimed in any preceding claim, characterised by including a bellows mounting bracket (34, 36; 84, 86) mounted on said housing about each said aperture and extending into the housing, said bellows (38, 40; 112, 114) being mounted at one end on a respective port and at the other end on a respective bracket.

**Patentansprüche**

1. Stellvorrichtung zur Verstellung eines gasgelagerten Arbeitstisches in zwei Richtungen (X und Y), mit ersten, zweiten und dritten Baugruppen (94, 11, 18), von denen die erste (94) stationär ist, mit Begrenzungseinrichtungen (108, 110, 78, 106) zwischen den ersten und zweiten Baugruppen (94, 11) zur Begrenzung der Relativbewegung zwischen diesen Baugruppen auf eine erste Richtung (Y—Y), mit Begrenzungseinrichtungen (26, 28, 72, 106) zwischen den zweiten und dritten Baugruppen (11, 18) zur Begrenzung der Relativbewegung zwischen diesen Baugruppen auf eine zweite Richtung (X—X) senkrecht zur ersten Richtung, mit Gaslagereinrichtungen (150) zwischen den ersten und zweiten Baugruppen und mit Gaslagereinrichtungen (56) zwischen den zweiten und dritten Baugruppen, dadurch gekennzeichnet, daß die bewegliche zweite Baugruppe ein gasdichtes Gehäuse (11) mit einer darin angeordneten in der Mitte liegenden Platte (106) einschließt, daß die ersten und dritten Baugruppen Schlitten (94, 18) in dem Gehäuse (11) auf beiden Seiten der in der Mitte angeordneten Platte (106) einschließen, daß ein Gaseinlaßanschluß (88, 22) an jedem Schlitten (94, 18) befestigt ist, wobei sich die Anschlüsse durch Öffnungen in dem Gehäuse (11) erstrecken, daß ein Gasauslaßanschluß (90, 24) an jedem Schlitten (94, 11) befestigt ist und sich durch eine Öffnung (132, 32) in dem Gehäuse erstreckt, daß die Gaslagereinrichtungen eine Vielzahl von Öffnungen (150, 56) auf der äußeren Oberfläche jedes Schlittens (94, 11) einschließen, die auf engbenachbarte Oberflächen der zweiten Baugruppe gerichtet ist, daß sich ein erster Kanal (96, 54) in jedem Schlitten (94, 11) zwischen dem jeweiligen Einlaßanschluß (88, 22) und den Öffnungen (150, 56) erstreckt, daß sich ein zweiter Kanal (60) in jedem Schlitten (94, 18) von der Außenoberfläche des Schlittens innerhalb des Gehäuses (11) zum jeweiligen Auslaßanschluß (90, 24) erstreckt, daß ein gasdichter Balg (38, 40, 112, 114) zwischen jeder Öffnung (30, 32) und dem sich durch diese erstreckenden Auslaß- oder Einlaßanschluß befestigt ist und eine gasdichte Abdichtung zwischen diesen Teilen bildet, daß ein Arbeitstisch (74) außerhalb des Gehäuses auf den Einlaß- und Auslaßanschlüssen (22, 24) des Schlittens (18) der dritten Baugruppe befestigt ist, so daß sich der Arbeitstisch frei in einer X—Y-Ebene gegenüber der ersten Baugruppe bewegen kann, und daß eine Druckgasquelle mit den Einlaßanschlüssen verbunden ist, so daß die Stellvorrichtung für den Arbeitstisch bei im Vakuum befindlichen gasdichten Gehäuse betreibbar ist.

2. Arbeitstisch nach Anspruch 1, dadurch gekennzeichnet, daß die Begrenzungseinrichtungen ein Paar von parallelen Schienen (26, 28; 108, 110) einschließen und daß jedes Paar orthogonal in dem Gehäuse (11) der zweiten Baugruppe befestigt ist.

3. Arbeitstisch nach Anspruch 1 oder 2, dadurch gekennzeichnet, daß jeder der Schlitten (18, 94) zwei mit Abstand angeordnete parallele Bauteile (80, 82) aufweist, die durch ein Mittelteil (20, 92) verbunden sind.

4. Arbeitstisch nach einem der vorhergehenden Ansprüche, dadurch gekennzeichnet, daß die in der Mitte angeordnete Platte (106) Ausnehmungen einschließt, in denen die Bälge (38, 40; 112, 114) teilweise angeordnet sind.

5. Arbeitstisch nach einem der vorhergehenden Ansprüche, dadurch gekennzeichnet, daß ein Balgbefestigungsträger (34, 36; 84, 86) an dem Gehäuse um jede Öffnung herum befestigt ist und sich in das Gehäuse erstreckt, und daß die Bälge (38, 40; 112, 114) mit einem Ende an einem jeweiligen Anschluß und mit dem anderen Ende an einem jeweiligen Balg-Befestigungsträger befestigt sind.

## Revendications

1. Dispositif de positionnement, dans les deux directions X et Y, à table à portée à gaz, comportant un premier, un second et un troisième ensembles (94, 11, 18) dont le premier (94) est fixe, des moyens de contrainte (108, 110, 78, 106) entre le premier et le second ensembles (94, 11) pour contraindre le mouvement relatif entre eux dans une première direction (Y—Y), des moyens de contrainte (26, 28, 72, 106) entre le second et le troisième ensembles (11, 18) pour contraindre le mouvement relatif entre eux dans une seconde direction (X—X) orthogonale à la première direction, des moyens formant portée à gaz (150) entre le premier et le second ensembles et des moyens formant portée à gaz (56) entre le second et le troisième ensembles caractérisé en ce que le second ensemble mobile comporte un carter étanche au gaz (11) comprenant une plaque centrale (106) montée dans le carter, en ce que le premier et le troisième ensembles comportant des chariots (94, 18) à l'intérieur du carter (11) de chaque côté de la plaque centrale (106), en ce qu'une ouverture d'entrée du gaz (88, 22) est prévue sur chaque chariot (94, 18), les ouvertures s'étendant à travers des passages dans le carter (11), en ce qu'une ouverture de sortie du gaz (90, 24) est prévue sur chaque chariot (94, 11) et s'étend à travers un passage (132, 32) dans le carter, en ce que les moyens formant portée à gaz comportent un certain nombre d'orifices (150, 56) sur la surface extérieure de chaque chariot (94, 11) qui se trouve très près en face des surfaces du second ensemble, en ce qu'un premier conduit (96, 54) dans chaque chariot (94, 11) s'étend à travers l'ouverture d'entrée respective (88, 22) et les orifices (150, 56), en ce qu'un second conduit (60) dans chaque chariot (94, 18) s'étend depuis la surface extérieure du chariot, à l'intérieur du carter (11), jusqu'à l'ouverture de sortie respective (90, 24), en ce que les soufflets étanches au gaz (38, 40, 112, 114) sont montés entre chaque passage (30, 32) et l'ouverture de sortie ou d'entrée, en s'étendant à travers eux et en réalisant entre eux une étanchéité au gaz, en ce qu'une table (74) est montée à l'extérieur du carter sur les ouvertures d'entrée et de sortie (22, 24) du chariot (18) du troisième ensemble de façon que ladite table soit libre de se déplacer dans un plan (X—Y) par rapport au premier ensemble, et en ce qu'une source de gaz sous pression communique avec les ouvertures d'entrée de façon que le dispositif de positionnement à table puisse fonctionner, le carter étanche au gaz étant placé dans une enceinte sous vide.

2. Table comme revendiquée dans la revendication 1, caractérisée en ce que chacun desdits moyens de contrainte comporte une paire de rails parallèles (26, 108, 110), chaque paire montée orthogonalement dans le carter (11) du second ensemble.

3. Table comme revendiquée dans la revendication 1 ou 2, caractérisée en ce que chacun desdits chariots (18, 94) comporte deux pièces parallèles espacées l'une de l'autre (80, 82) reliées par une pièce centrale (20, 92).

4. Table comme revendiquée dans l'une quelconque des revendications précédentes, caractérisée en ce que ladite plaque centrale (106) comporte des niches dans lesquelles lesdits soufflets (38, 40; 112, 114) sont partiellement logés.

5. Table comme revendiquée dans l'une quelconque des revendications précédentes, caractérisée par le fait qu'elle comporte une boite (34, 36; 84, 86) de montage du soufflet montée sur ledit carter autour de chaque dite ouverture et s'étendant dans le carter, lesdits soufflets (38, 40; 112, 114) étant montés à une extrémité sur une ouverture respective et à l'autre extrémité sur un boite respective.

Fig.1

Fig.2

Fig.4

Fig.3

Fig.5